# EUROPEAN PATENT APPLICATION

(11) **EP 0 936 849 A1**
(43) Date of publication of application: **18.08.1999**
(21) Application number: 99301048.7
(22) Date of filing: 12.02.1999
(51) Int. Cl.: H05K 1/05

(54) **Printed circuit assembly and method of making the same**

(30) Priority: 17.02.1998 GB 9803236
(71) Applicant: Pressac Interconnect Limited, Long Eaton, Nottingham NG10 1FW (GB)
(72) Inventor: Swift, Michael Philip, Long Eaton, Nottingham NG10 1PP (GB)
(74) Representative: Gilding, Martin John

(57) **Abstract**

A printed circuit assembly (10) comprising an aluminium substrate (12) having an anodised layer (14,15) on at least one surface of the substrate (12), and circuit conductors (16,18,20,21) on the surface of the anodised layer (14,15) remote from the substrate (12). A method of forming the circuit assembly (10) and electrical apparatus using the printed circuit assembly (10) are also described.

## Description

This invention is concerned with printed circuit assemblies and methods of making the same.

In some printed circuit applications, components of electrical apparatus carried by a printed circuit assembly generate a considerable amount of heat and, in order that the components operate correctly and that the printed circuit assembly is not damaged, it is necessary to remove the excess heat. It has been necessary, in many cases, to provide heat-sinks by which the excess heat is conducted away from the printed circuit elements and this may be used in conjunction with a fan to provide forced cooling. Typically, a printed circuit assembly of known construction is mounted directly to a heat-sink so that heat from the circuit assembly is conducted away by the heat-sink; individual circuit components may also be provided with their own heat-sinks and/or cooling means.

It is one of the various objects of the present invention to provide a printed circuit assembly providing an improved heat-sink.

In one aspect the invention may be considered to provide a printed circuit assembly comprising an aluminium substrate having an anodised layer on at least one surface of the substrate, and circuit conductors on the surface of the anodised layer remote from the substrate.

Preferably, the anodised layer is at least 5 microns thick; suitably the layer is about 25 microns thick.

In a preferred assembly in accordance with the invention the substrate is a sheet of aluminium.

In a preferred assembly in accordance with the invention the substrate may be provided by any thermally conducting aluminium alloy which can be anodised.

If desired an assembly in accordance with the invention wherein the substrate is an aluminium sheet, the substrate may have two anodised layers, one on each face of the sheet.

In one assembly in accordance with the invention, one or more openings may be formed in the anodised layer and conductors may make electrical contact with the aluminium exposed in the openings. These conductors may be circuit conductors which are provided on the surface of the anodised layer and extend onto the aluminium in the openings, or may be conductors of circuit components carried by the printed circuit assembly, or may be provided by external conductors eg to make electrical contact for a power supply to the aluminium substrate.

Conveniently, an assembly in accordance with the invention may have at least one hole extending through the aluminium substrate, the surface of the substrate which defines said at least one hole having an anodised layer thereon.

Preferably, the circuit conductors of a printed circuit assembly in accordance with the invention are screen printed onto the surface of the anodised layer. Conveniently, the circuit conductors are screen printed using a conductive ink which is solderable; for example the conductive ink may comprise a suitable polymer loaded with conductive powder eg conductive metal powder, for example silver. However, any other suitable means may be utilised to form the circuit conductors for example electroless plating/deposition of the conductive material, vacuum deposition of the conductive material, or application of a seed polymer (which can be a conductive or non-conductive layer) that can be metalised eg "Homer", "Baymetec", "Baycoflex".

In another aspect the invention may be considered to provide a method of making a printed circuit assembly comprising the steps of
(i) procuring an aluminium substrate
(ii) anodising the substrate to form an anodised layer on the substrate
(iii) forming a pattern of circuit conductors on the surface of the anodised layer remote from the substrate.

In a preferred method as set out in the last preceding paragraph, before carrying out step (ii), at least one hole is made through the substrate whereby when step (ii) is carried out, an anodised layer is formed on the surface of the substrate defining the hole.

Preferably, in a method in accordance with the invention, before carrying out step (ii), at least one region of the substrate is treated to prevent anodising of that region, whereby to provide an opening in the anodised layer. Electrical connection to the substrate may then be made by contact with the region of the substrate which is exposed through the opening. Conveniently, to form the opening, the substrate is treated by applying a pattern of anodising resist to the substrate before anodising and removing the resist after anodising to expose the aluminium substrate in those regions.

Preferably, in carrying out a method in accordance with the invention the circuit conductors are formed by screen printing a polymer composition loaded with electrically conductive powder onto the anodised layer.

A printed circuit assembly in accordance with the invention is preferably made by a method in accordance with the invention.

In yet another aspect the invention may be considered to provide electrical apparatus comprising a printed circuit assembly in accordance with the invention and a plurality of circuit components mounted on the assembly in electrical contact with the circuit conductors.

Preferably, in apparatus in accordance with the invention, at least one of the components is in electrical contact with the aluminium substrate which itself provides a conductor of the electrical apparatus.

In a preferred electrical apparatus in accordance with the invention an aluminium substrate sheet has an anodised layer on both faces of the substrate, each anodised layer having circuit conductors thereon and carrying electrical components, the substrate being arranged to provide a ground plane to electrically shield the circuit on one anodised layer from that on the other.

There now follows a detailed description, to be read with reference to the accompanying drawings, of a printed circuit assembly, a method of making same and electrical apparatus embodying the invention. It will be realised that this circuit assembly, method and apparatus have been selected for description to illustrate the invention by way of example and not of limitation of the invention.

In the accompanying drawings:-
Figure 1 is a diagrammatic plan view with parts broken away of a printed circuit assembly embodying the invention; and
Figure 2 is a diagrammatic view in section on the line II-II of Figure 1.

The illustrative printed circuit assembly 10 comprises an aluminium alloy substrate 12 which has good conductivity of electricity and of heat. Anodised layers 14, 15 are formed on both faces of the substrate 12 which is in the form of an aluminium sheet. Circuit conductors 16, 18, 20, 21 are printed on the surfaces of the anodised layers 14, 15 remote from the substrate 12.

A hole 22 extends through the aluminium substrate 12 and the surface of the substrate defining the hole 22 has an anodised layer 24 thereon; the anodised layer is continuous with the anodised layers 14 and 15 on the opposite surfaces of the aluminium substrate 12.

The anodised layers 14, 15, 24 are about 25 microns thick.

The illustrative printed circuit assembly also has openings 26, 28 in the anodised layer. Conductors may be in electrical contact with the regions of the aluminium substrate 12 exposed in the openings 26, 28. For example in the illustrative assembly, one of the circuit conductors 21 printed on the surface of the assembly makes electrical contact with the aluminium exposed through the opening 28, whilst an electrical cable 30 is electrically connected to the aluminium substrate 12 exposed by the opening 26.

The illustrative printed circuit assembly is made by a method embodying the invention in which a sheet of a suitable electrically and heat conductive aluminium alloy 12 is first procured. Any necessary holes, for example the hole 22, are then made for example by drilling through the substrate.

Next in carrying out the illustrative method patterns of anodising resist are applied to the substrate at selected regions of the substrate corresponding with the regions which the openings 26, 28 are required. The anodising resist is applied to the surface of the substrate 12 by a photographic imaging technique.

The aluminium substrate 12 is then hard anodised by methods which are well known by those skilled in the art, to provide the anodised layers 14, 15, 24 on the surfaces of the substrate 12. No anodised layer is formed on those regions of the substrate 12 which have previously been treated with the anodising resist.

After anodising, the anodising resist is removed to provide the openings 26, 28 through the hard anodised layers 14, 15 leaving the aluminium substrate exposed through the openings 26, 28.

The hard anodised layers 14, 15, 24 have good thermal conductivity whilst being electrically non-conductive.

After the anodised layers 14, 15, 24 have been formed desired patterns of electrical circuit conductors are applied to the surfaces of the layers 14, 15 remote from the substrate 12. Suitably, the conductors 16, 18, 20, 21 are applied by screen printing techniques which are well known to those skilled in the art.

The illustrative printed circuit assembly can be utilised to provide electrical apparatus in accordance with the invention on which a plurality of circuit components 32, 34 are mounted on the assembly in electrical contact with the circuit conductors 16, 18; 16, 21 respectively.

In the illustrative apparatus, where the circuit conductors are formed by a solderable conductive layer, the components may be electrically connected by soldering to printed pads of 17, 19, 23 of the conductors 16, 18, 21.

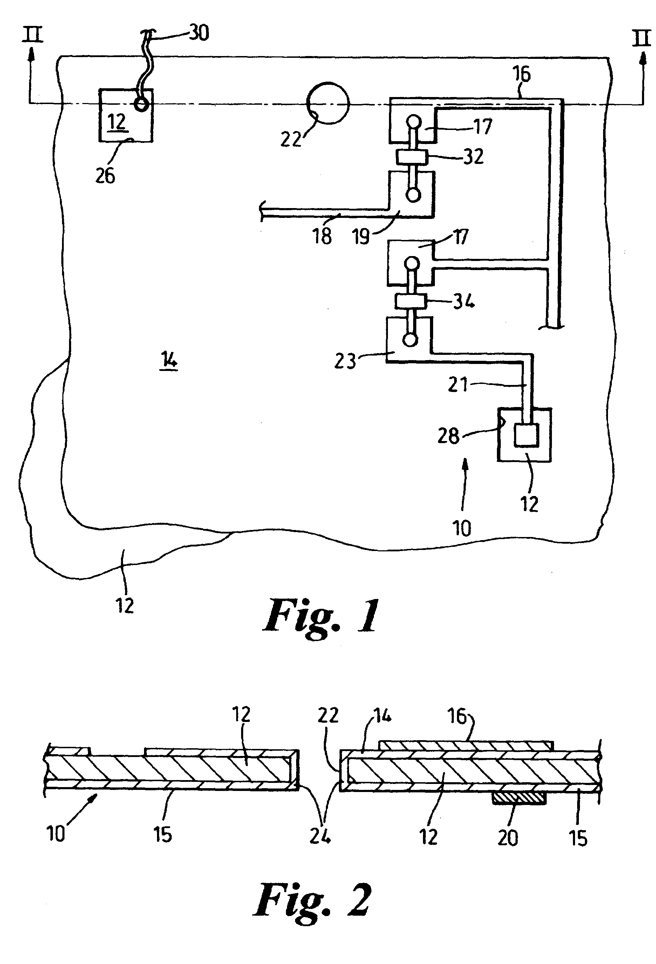

The circuit conductors are provided in any desired pattern on the anodised layer to provide an electrical circuit suitable for the apparatus to be made and the circuit conductors shown in Figure 1 are diagrammatic and provided merely by way of example.

As previously mentioned the openings 26, 28 can be used to make electrical connections to the substrate for a variety of purposes; for example, the aluminium substrate 12 itself may provide a common conductor for the electrical apparatus; for example it may provide a ground or a zero voltage power supply line. Where circuit conductors are applied on both sides of the aluminium substrate 12, the substrate 12 may provide a ground which acts as an electrical shield between the circuit conductors on the anodised layer 14 on one side of the circuit from the circuit conductors formed on the anodised layers 15 on the other side of the circuit thus, minimising or entirely eliminating signal interference between the circuits on the opposite faces of the substrate.

The use of the aluminium substrate as a common conductor allows for more efficient layout of the patterns of circuit conductors because this effectively eliminates a track path from the circuit conductors which are applied to the substrate 12.

Holes, for example the hole 22, formed through the aluminium before anodising can be used in electrical apparatus embodying the invention for a variety of purposes. For example, the hole 22 may be used as a location or retention hole. Because the anodised layer 24 provides electrical insulation no special insulating means are required when using holes such as the hole 22 either as location or retention holes for the apparatus. Furthermore, as the anodising is thermally conductive this can allow thermal connection externally of the apparatus or to other parts of the electrical apparatus of which the illustrative printed circuit assembly forms part.

Alternatively, the hole 22 may provide a means of discrete connection between the opposite faces of the circuit assembly using electrical standard through hole circuit connection methods for example, electrically conductive rivets, electro-plate metallic through-hole connections or printed through-hole connection techniques may provide electrical connection through the hole 22 between circuit conductors on the layers 14 and 15 on the opposite faces of the substrate 12 as necessary.

Although one hole 22 is shown in the illustrative printed circuit assembly it will be understood that a plurality of holes may be formed through the substrate 12.

Although the illustrative printed circuit assembly is produced as a flat sheet of aluminium, the aluminium could in forming printed circuit assemblies otherwise similar to the illustrative printed circuit assembly, be preformed or post-formed to provide a circuit which is not planar; for example, the aluminium substrate 12 may be preformed or post-formed to create brackets or heat-sink fins.

The aluminium substrate 12 as the base on to which the circuit conductors are applied itself provides a very efficient heat-sink which can be utilised to transfer heat away from the circuit conductors and components which are mounted on the circuit assembly in making an electrical apparatus. For many circuit applications this will avoid the need to have separate heat-sinks mounted to individual circuit components and will tend to minimise the requirements for heat-sinks in general. As the anodised layers 14, 15, 24 are very thermally conductive, the thermal conductivity from the circuit pattern, and component terminals is very effective and it is believed that the heat transfer coefficient is improved, compared with the mounting of a specific heat-sink to a component body. The hard anodised layer, as previously mentioned, provides an effective electrical insulation and, so long as the hard anodised layers 14, 15, 24 are of sufficient thickness there is no possibility of electrical shorting. It is believed that a thickness of about 25 microns provides a suitable thickness for the anodised layers, although thinner layers may be effective.

Electrical apparatus in accordance with the invention may be utilised for a variety of purposes; for example, where a printed circuit is required to mount a mixture of light emitting diodes, incandescent tungsten filament bulbs and, possibly, control circuitry which may be provided by microchips (for example, in automobile applications) the dispersal of heat may be a major problem and a printed circuit assembly in accordance with the invention may be useful in minimising the difficulties of heat dispersal.

It will be appreciated that in view of the method by which the hard anodised layers 14, 15 24 are formed, it is extremely unlikely that any problems will arise due to delamination between the insulating layer (provided by the anodised layers) and conductive layer provided by the aluminium substrate 12.

## Claims

1. A printed circuit assembly comprising an aluminium substrate having an anodised layer on at least one surface of the substrate, and circuit conductors on the surface of the anodised layer remote from the substrate.

2. An assembly according to claim 1 wherein the anodised layer is at least 15 µm thick.

3. An assembly according to either one of the preceding claims wherein the substrate is a sheet of aluminium.

4. An assembly according to claim 3 having two anodised layers, one on each face of the sheet.

5. An assembly according to any one of the preceding claims having at least one opening in the anodised layer and at least one conductor making electrical contact with the aluminium exposed in the at least one opening.

6. An assembly according to any one of the preceding claims having at least one hole extending through the aluminium substrate, the surface of the substrate defining said at least one hole having an anodised layer thereon.

7. An assembly according to any one of the preceding claims wherein the circuit conductors are screen printed onto the surface of the or each anodised layer.

8. A printed circuit assembly substantially as hereinbefore described with reference to the accompanying drawings.

9. A method of making a printed circuit assembly comprising the steps of
(i) procuring an aluminium substrate
(ii) anodising the substrate to form an anodised layer on the substrate
(iii) forming a pattern of circuit conductors on the surface of the anodised layer remote from the substrate.

10. A method according to claim 9 also comprising, before carrying out step (ii), making at least one hole through the substrate whereby when step (ii) is carried out, an anodised layer is formed on the surface of the substrate defining the hole.

11. A method according to either one of claims 9 and 10 wherein before carrying out step (ii), at least one region of the substrate is treated to prevent anodising of that region, whereby to provide an opening in the anodised layer.

12. A method according to claim 11 wherein the substrate is treated by applying a pattern of anodising resist to the substrate before anodising and removing the resist after anodising to expose the aluminium substrate in said at least one region.

13. A method according to any one of claims 9 to 12 wherein the circuit conductors are formed by screen printing a polymer composition loaded with electrically conductive powder on the anodised layer.

14. , A printed circuit assembly according to any one of claims 1 to 8 made by a method according to any one of claims 9 to 13.

15. An electrical apparatus comprising a printed circuit assembly according to any one of claims 1 to 8 and a plurality of circuit components mounted on the assembly in electrical contact with the circuit conductors.

16. Apparatus according to claim 15 wherein at least one of the components is in electrical contact with the aluminium substrate which itself provides a conductor of the electrical apparatus.

17. Apparatus according to claim 15 including an aluminium substrate sheet having an anodised layer on both faces of the substrate, each anodised layer having circuit conductors thereon and carrying electrical components, the substrate being arranged to provide a ground plane to electrically shield the circuits on one anodised layer from those on the other.
